# EUROPÄISCHE PATENTSCHRIFT

(11) **EP 3 035 785 B1**
(45) Veröffentlichungstag und Bekanntmachung des Hinweises auf die Patenterteilung: **19.09.2018**
(21) Anmeldenummer: 15196931.8
(22) Anmeldetag: 30.11.2015
(51) Int. Cl.: H05K 13/04

(54) **VORRICHTUNG UND VERFAHREN ZUM AUTOMATISIERTEN BESTÜCKEN EINER LEITERPLATTE MIT ZUMINDEST EINEM ELEKTRONISCHEN BAUTEIL**
DEVICE AND METHOD FOR THE AUTOMATED MOUNTING OF AT LEAST ONE ELECTRONIC COMPONENT ON A PRINTED CIRCUIT BOARD
DISPOSITIF ET PROCEDE D'IMPLANTATION AUTOMATISEE D'AU MOINS UN COMPOSANT ELECTRONIQUE DANS UNE PLAQUETTE

(30) Priorität: 18.12.2014 DE 102014119077
(43) Veröffentlichungstag der Anmeldung: 22.06.2016
(73) Patentinhaber: Endress+Hauser SE+Co. KG, 79689 Maulburg (DE)
(72) Erfinder: Grether, Florian, 79597 Schallbach (DE); Schwanz, Erik, 79585 Steinen (DE); Braun, Dieter, 79400 Kandern (DE)
(74) Vertreter: Andres, Angelika Maria

(56) Entgegenhaltungen:
- EP-A1- 2 259 672
- DE-A1- 10 108 845
- JP-A- H05 162 093
- US-A1- 2002 036 411

## Beschreibung

Die Erfindung betrifft eine Vorrichtung zum automatisierten Bestücken einer Leiterplatte mit zumindest einem elektronischen Bauteil. Des Weiteren betrifft die Erfindung ein Verfahren zum automatisierten Bestücken einer Leiterplatte mit zumindest einem elektronischen Bauteil.

In der Automatisierungstechnik, insbesondere in der Prozessautomatisierungstechnik, werden vielfach Feldgeräte eingesetzt, die zur Erfassung und/oder Beeinflussung von Prozessvariablen dienen. Zur Erfassung von Prozessvariablen dienen Sensoren, die beispielsweise in Füllstandsmessgeräten, Durchflussmessgeräten, Druck- und Temperaturmessgeräten, pH-Redoxpotential-Messgeräten, Leitfähigkeitsmessgeräten, usw. integriert sind, welche die entsprechenden Prozessvariablen Füllstand, Durchfluss, Druck, Temperatur, pH-Wert, Redoxpotantial bzw. Leitfähigkeit erfassen. Zur Beeinflussung von Prozessvariablen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Als Feldgeräte werden im Prinzip alle Geräte bezeichnet, die prozessnah eingesetzt werden und die prozessrelevante Informationen liefern oder verarbeiten. Im Zusammenhang mit der Erfindung werden unter Feldgeräten also auch Remote I/Os, Funkadapter bzw. allgemein elektronische Komponenten verstanden, die auf der Feldebene angeordnet sind. Eine Vielzahl solcher Feldgeräte wird von der Firma Endress + Hauser hergestellt und vertrieben.

Den verschiedenen Feldgeräte-Typen ist gemeinsam, dass sie elektronische Komponenten im Gehäuseinneren aufweisen, welche auf Leiterplatten angebracht sind. Bei der Fertigung der Feldgeräte erfolgt das Bestücken solcher Leiterplatten größtenteils automatisiert durch Bestückungsautomaten. In diesen Fällen, insbesondere beim Pick- and Place-Verfahren wird das elektronische Bauteil durch eine Greif- und Positionier-Einheit mittels einer Vakuum-Pipette angesaugt, die das elektronische Bauteil in aufeinanderfolgenden Schritten
1) an einem Aufnahmeort in einer Aufnahmeposition von einer Aufnahmefläche aufnimmt,
2) auf einem Transportweg transportiert, und
3) an einem Zielort auf der Leiterplatte positioniert.
Das Bestücken der Leiterplatte stellt für die zu bestückenden elektronischen Bauteile einen kritischen Prozess dar: Während des Prozesses kann es zu elektrostatischer Aufladung des Bestückungsautomaten oder des elektronischen Bauteils kommen kann. Die dabei entstehenden Ladungen können Spannungen bis zu 10 kV erzeugen. Entlädt sich die elektrostatische Ladung über das elektronische Bauteil, so kann dies zur Zerstörung des Bauteils führen. Dieses Phänomen ist im Allgemeinen bereits seit langem bekannt und wird im englischen als electrostatic discharge , kurz ESD, bezeichnet. Aufgrund ihrer Empfindlichkeit gegen hohe Spannungen sind insbesondere Halbleiterbauelemente anfällig für Zerstörung durch elektrostatische Entladung.

Für solche Fälle wurden bereits interne Schutzkreise für Halbleiterbauelemente entwickelt, die als zusätzliche Schutzschaltungen in Halbleiterbauelementen implementiert werden können. Solch eine Schutzschaltung ist unter anderem in EP 0 697 757 A1 beschrieben. Sie beschreibt einen Schutz-Schaltkreis, der im Fall einer elektrostatischen Entladung durch einen internen Schalter aktiviert wird und die elektrische Ladung je nach Polarität über eine in Durchlassrichtung geschaltete Diode ableitet. Hierdurch wird der zu schützende Teil der Schaltung nicht vom elektrostatisch hervorgerufenen Strompuls durchflossen. Das Dokument DE10108845 offenbart eine Vorrichtung gemäß dem Oberbegriff des Anspruchs 1. Solche Schutzkreise sind allerdings nur wirksam, wenn die elektronischen Bauteile nach dem Faraday schen Prinzip gekapselt sind.

Ist dies nicht der Fall, sind interne Schutzkreise wirkungslos, da die elektrostatisch hervorgerufenen Strompulse über jeden beliebigen Teil der Halbleiter-Oberfläche eindringen können.
Daher sind nur teilweise oder nicht gekapselte Halbleiterbauelemente beim automatisierten Bestücken besonders gefährdet, so dass bereits Spannungen in der Größenordnung von 20 V ausreichen, um das elektronische Bauteil zu zerstören.
Bei verschiedenen Anwendungen ist es allerdings erforderlich, die Halbleiterbauelemente ungekapselt auf der Leiterplatte zu bestücken, wenn es zum Beispiel aus Platzgründen notwendig ist. In solchen Fällen ist das Halbleiterbauelement in der Regel als Surface-Mounted Device , kurz SMD Bauteil, konzipiert. Dies bedeutet, dass das Bauteil derart ausgelegt ist, dass es direkt an der Oberfläche der Leiterplatte elektrisch kontaktiert wird.

Aus diesem Grund ist beim Bestückungsprozess von nicht gekapselten elektronischen Bauteilen nicht nur die Aufnahme sowie das Positionieren des elektronischen Bauteils kritisch. Vielmehr können solche Spannungen auch dann entstehen, wenn sich das Halbleiterbauelement aufgrund der Luftreibung beim Transport zu dessen Zielort auf der Leiterplatte elektrostatisch auflädt, da hier Transportgeschwindigkeiten von mehreren Metern pro Sekunde erreicht werden.

Neben dem Schutz des elektronischen Bauteils vor Zerstörung durch elektrostatische Aufladung ist auch die Ausrichtung des elektronischen Bauteils zur Vakuum-Pipette während des Bestückungsvorgangs von Bedeutung. Vor allem bei elektronischen Bauteilen mit Kontakt-Stiften ist eine exakte Ausrichtung zur Vakuum-Pipette notwendig, da die Kontakt-Stifte dieser Bauteile beim Positionieren auf der Leiterplatte zu den für sie vorgesehenen Anschlusslöchern auf der Leiterplatte fluchten müssen. Um dies zu gewährleisten, muss das zu bestückende elektronische Bauteil bereits am Aufnahmeort hinreichend exakt ausgerichtet sein, so dass es durch die Vakuum-Pipette mit der bereits richtigen Ausrichtung gegriffen wird. Dies kann jedoch speziell für kleine Bauteile schwierig sein, da beim automatisierten Bestücken die elektronischen Bauteile über Gurte mit Taschen bereitgestellt werden, in denen die elektronischen Bauteile gegebenenfalls nur vage ausgerichtet sind.
Der Erfindung liegt daher die Aufgabe zugrunde, das zu bestückende elektronische Bauteil bei automatisierter Bestückung vor Zerstörung durch elektrostatische Aufladung zu schützen und/oder als Ausrichthilfe beim Aufnehmen des elektronischen Bauteils zu dienen.

Die Aufgabe wird erfindungsgemäß durch eine Vorrichtung gemäß Anspruch 1.

Hierbei sind die Innenfläche der hülsenförmigen Komponente und die Außenfläche der Vakuum-Pipette derart ausgestaltet, dass in der Aufnahmeposition die Spitze der Vakuum-Pipette im Wesentlichen in einer durch die Unterkante der hülsenförmigen Komponente aufgespannten Ebene liegt, und dass die Unterkante der hülsenförmigen Komponente in der Transportposition um eine definierte Strecke in Richtung der Verjüngung der Vakuum-Pipette versetzt ist.
Hierdurch nimmt die hülsenförmige Komponente in der Transportposition eine das Bauteil seitlich komplett umschließende Position ein, in der das elektronische Bauteil vor Luftreibung geschützt ist. In der Aufnahmeposition ist die Hülse entlang der Längsachse der Vakuum-Pipette verschoben, so dass sie das elektronische Bauteil seitlich nicht komplett umschließt. Nach dem Aufnehmen und dem damit verbundenen Wechsel der hülsenförmigen Komponente in die Transportposition wird das elektronische Bauteil durch die Innenfläche der Hülse in eine festgelegte Position zur Vakuum-Pipette ausgerichtet.

In einer vorteilhaften Ausgestaltung ist der Versatz der Unterkante der hülsenförmigen Komponente in Richtung der Verjüngung der Vakuum-Pipette in der Transportposition durch Kontakt zwischen einem ersten, auf der Außenfläche der Vakuum-Pipette befindlichen Anschlag und einem zweiten, sich auf der Innenfläche (4) der hülsenförmigen Komponente befindlichen und mit dem ersten Anschlag korrespondierender Anschlag bestimmt, wobei sich der erste Anschlag in Bezug zur Längsachse der Vakuum-Pipette zwischen dem zweiten Anschlag und der Unterkante der hülsenförmigen Komponente befindet.

In einer weiteren vorteilhaften erfindungsgemäßen Ausgestaltung der Vorrichtung weist die hülsenförmige Komponente einen runden Querschnitt auf.
Die runde Ausgestaltung vereinfacht die Fertigung der hülsenförmigen Komponente, da in diesem Fall auf Dreh- und Bohrverfahren zurückgegriffen werden kann. Es versteht sich von selbst, dass die hülsenförmige Komponente auch andersförmige Querschnitte, wie beispielsweise ovale, rechteckige oder ähnliche Querschnitte aufweisen kann.

Vorzugsweise sind der erste Anschlag und/oder der zweite Anschlag als ringförmiger Steg ausgebildet.
Diese korrespondiert zur Ausgestaltungsform der hülsenförmigen Komponente mit rundem Querschnitt.

In einer vorteilhaften Form der erfindungsgemäßen Ausgestaltung besteht die hülsenförmige Komponente aus zumindest zwei Teilkomponenten, die in Kontakt sind,
wobei eine erste Teilkomponente den zweiten Anschlag umfasst und eine zweite Teilkomponente eine Hülse umfasst.

Dies erleichtert die Montage der hülsenförmigen Komponente an der Vakuum-Pipette, wobei der Kontakt beispielsweise über eine Schraubverbindung hergestellt werden kann.

Weiter vorteilhaft ist es, wenn die hülsenförmige Komponente oberhalb der Unterkante eine Verjüngung und/oder einen verkleinerten Querschnitt aufweist.
Hierdurch wird das elektronische Bauteil seitlich enger umschlossen, so dass Luftverwirbelungen und die damit verbundene Luftreibung am elektronischen Bauteil während des Transports weiter reduziert werden.

Bevorzugt ist an der Innenfläche der hülsenförmigen Komponente zumindest ein Steg vorgesehen, der die Oberseite des elektronischen Bauteils zumindest teilweise abdeckt.
Auch diese Ausgestaltungsvariante dient dem Zweck, Luftverwirbelungen und damit verbundene Luftreibung am elektronischen Bauteil während des Transportes weiter zu reduzieren.

Vorzugsweise besteht die hülsenförmige Komponente zumindest teilweise aus einem elektrisch leitfähigen Material, insbesondere einem ESD-leitfähigen Material.
Hierdurch wirkt die Hülse beim Aufnehmen sowie beim Positionieren des elektronischen Bauteils als Schutzableiter zwischen der Vakuum-Pipette und dem Substrat, so dass im Falle elektrostatischer Aufladung an der Greif- und Positioniereinheit die elektrische Ladung nicht über das elektronische Bauteil abgeleitet wird.

Eine weitere vorteilhafte Ausgestaltung der hülsenförmigen Komponente weist Aussparungen und/oder Durchbohrungen auf.
Diese gewichtsreduzierte Ausgestaltungsform weist die Aussparungen und/oder Durchbohrungenan insbesondere an den Stellen auf, welche das elektronische Bauteil nicht umschließen,

Eine bevorzugte Ausgestaltungsform der Vorrichtung sieht vor, dass es sich bei dem vor ESD-Schäden zu schützenden elektronischen Bauteil um ein SMD Bauteil handelt.
Bevorzugt handelt es sich bei dem auszurichtenden elektronischen Bauteil um ein Bauteil mit zumindest einem Anschluss-Stift handelt.

Die Aufgabe wird des weiteren erfindungsgemäß durch ein Verfahren gemäß Anspruch 12.

Durch diesen Verfahrensablauf ist das elektronische Bauteil während des Transportes seitlich komplett umschlossen und schützt vor Luftreibung. Außerdem wird durch den Versatz der hülsenförmigen Komponente nach dem Aufnehmen des elektronischen Bauteils dieses mittels der Innenfäche der hülsenförmigen Komponente bei entsprechender Hülsengeometrie oberhalb der Unterkante der hülsenförmigen Komponente zur Vakuum-Pipette ausgerichtet.

In einer bevorzugten Variante des Verfahrens wird die hülsenförmige Komponente beim Aufnehmen des elektronischen Bauteils am Aufnahmeort durch das Auftreffen der Unterkante auf die Aufnahmefläche entlang der Längsachse verschoben, so dass die Spitze der Vakuum-Pipette im Wesentlichen in einer durch die Unterkante der hülsenförmigen Komponente aufgespannten Ebene liegt, und
wobei die hülsenförmige Komponente beim Positionieren des elektronischen Bauteils am Zielort durch das Auftreffen der Unterkante auf die Leiterplatte entlang der Längsachse verschoben wird, so dass die Spitze der Vakuum-Pipette im Wesentlichen in einer durch die Unterkante der hülsenförmigen Komponente aufgespannten Ebene liegt.
Auf diese Weise ist sichergestellt, dass die hülsenförmige Komponente das Aufnehmen sowie das positionieren der elektrischen Komponente nicht behindert. Außerdem ist durch diese Verfahrensvariante ein passives Hochschieben der hülsenförmigen Komponente beim Aufnehmen durch das Auftreffen der Unterkante der hülsenförmigen Komponente auf die Aufnahmefläche gegeben. Ebenso ist ein passives Hochverschieben der hülsenförmigen Komponente beim Positionieren des elektronischen Bauteils durch das Auftreffen der Unterkante der hülsenförmigen Komponente auf dieLeiterplatte gegeben.

In einer weiteren vorteilhaften Ausgestaltung des erfindungsgemäßen Verfahrens wird der Versatz der Unterkante der hülsenförmigen Komponente in der Transportposition durch das Eigengewicht der hülsenförmigen Komponente bewirkt. Hierdurch geschieht das Verschieben der hülsenförmigen Komponente in die Transportposition auf passive Weise.

Nachfolgend wird der Gegenstand der Erfindung anhand eines Ausführungsbeispiels in zwei beigefügten Figuren näher erläutert. Sie zeigt:
Fig. 1: Einen Querschnitt einer hülsenförmigen Komponente an einer Vakuum-Pipette 2 in der Transportposition.
Fig. 2: Einen Querschnitt der hülsenförmigen Komponente an der Vakuum-Pipette 2 in der Aufnahmeposition.

In beiden Figuren ist eine Querschnitts-Ansicht der hülsenförmigen Komponente 3 um die sich zu einer Spitze verjüngenden Vakuum-Pipette 2 zu sehen, wobei sich an der Vakuum-Pipette 2 das elektronisches Bauteil 1 befindet. Sofern die hülsenförmige Komponente 3 dem Schutz vor ESDbedingter Zerstörung dient, so handelt es sich bei dem elektronischen Bauteil 1 vorzugsweise um ein SMD-Bauteil. In dem Fall, in dem die hülsenförmige Komponente 3 dem Ausrichten des elektronischen Bauteils 1 beim Aufnehmen dient, ist das elektronische Bauteil 1 vorzugsweise ein Bauteil mit zumindest einem Kontakt-Stift.
Die Ausgestaltung der hülsenförmigen Komponente 3 ist in beiden Figuren identisch, sie weist einen runden Querschnitt auf und teilt sich in eine erste Teilkomponente 12 und eine zweite Teilkomponente 13. Dementsprechend ist ein erster Anschlag 7 an der Außenfläche der Vakuum-Pipette 2 als ringförmiger Steg ausgestaltet, ein zu ihm korrespondierende Anschlag 8 an der Innenseite der hülsenförmigen Komponente 3 ist ebenfalls als ringförmiger Steg ausgebildet. Zu sehen ist in beiden Figuren auch die Ausgestaltung der hülsenförmigen Komponente 3 mit verkleinertem Querschnitt oberhalb ihrer Unterkante 6. In den beiden Darstellungen weist die hülsenförmige Komponente 3 einen Steg 10 auf, der die Oberseite des elektronischen Bauteils 1 zumindest teilweise abdeckt.

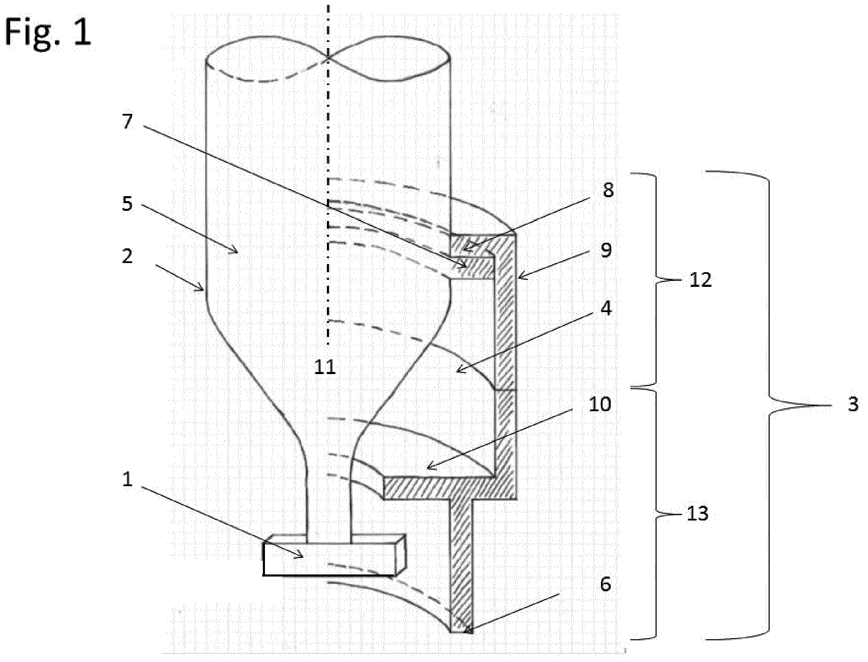

In Fig. 1 ist die hülsenförmige Komponente 3 in der Aufnahmeposition zu sehen. In dieser Position, die beim Aufnehmen des elektronischen Bauteils 1 am Aufnahmeort sowie beim Positionieren des elektronischen Bauteils 1 am Zielort vorliegt, befindet sich die Spitze der Vakuum-Pipette 2 im Wesentlichen in einer durch die Unterkante 6 der hülsenförmigen Komponente 3 aufgespannten Ebene. Dies wird durch das Aufliegen der Unterkante 6 auf einem Substrat 14 bewirkt. Beim Aufnehmen des elektronischen Bauteils 1 handelt es sich bei dem Substrat 14 um die Aufnahmefläche, beim Positionieren ist dies die Leiterplatte.

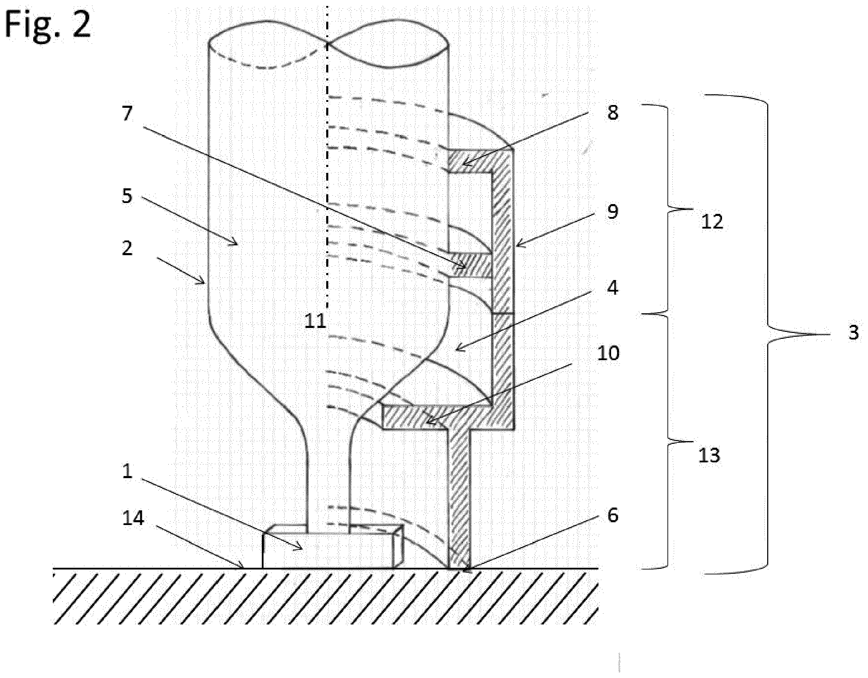

Im Unterschied zu Fig. 1 ist in Fig. 2 die Unterkante 6 der hülsenartigen Komponente 3 in Richtung der sich verjüngenden Vakuum-Spitze 2 versetzt. Diese Position nimmt die hülsenförmige Komponente 3 schwerkraftbedingt in der Transportposition des elektronischen Bauteils 1 zum Zielort auf der Leiterplatte ein. Der Versatz wird durch den ersten Anschlag 7 und den zweiten Anschlag 8 definiert, die in dieser Position in Kontakt miteinander sind. Die Figur 2 zeigt, dass das elektronische Bauteil 1 durch den Versatz der hülsenförmigen Komponente 3 seitlich komplett umschlossen ist, so dass es beim Transport zum Zielort vor Luftreibung geschützt ist und nicht elektrostatisch aufgeladen werden kann.

### Bezugszeichenliste

- 1: Elektronisches Bauteil
- 2: Vakuum-Pipette
- 3: Hülsenförmige Komponente
- 4: Innenfläche der hülsenförmigen Komponente
- 5: Außenfläche der Vakuum-Pipette
- 6: Unterkante der hülsenförmigen Komponente
- 7: Erster Anschlag
- 8: Zweiter Anschlag
- 9: Hülse
- 10: Steg
- 11: Längsachse der Vakuum-Pipette
- 12: Erste Teilkomponente
- 13: Zweite Teilkomponente
- 14: Substrat

## Patentansprüche

1. Vorrichtung zum automatisierten Bestücken einer Leiterplatte mit zumindest einem elektronischen Bauteil (1), umfassend
- eine sich zu einer Spitze verjüngenden Vakuum-Pipette (2), wobei die Vakuum-Pipette (2) dazu eingerichtet ist, das elektronische Bauteil (1) an einem Aufnahmeort in einer Aufnahmeposition von einer Aufnahmefläche aufzunehmen, auf einem Transportweg in einer Transportposition zu transportieren und an einem Zielort auf der Leiterplatte zu positionieren, und
- eine hülsenförmigen Komponente (3), die die Vakuum-Pipette (2) in einem Teilbereich umgibt und die in Richtung der Längsachse der Vakuum-Pipette (11) verschiebbar gelagert ist,
wobei die Innenfläche (4) der hülsenförmigen Komponente (3) und die Außenfläche der Vakuum-Pipette (5) derart ausgestaltet sind,
dass in der Aufnahmeposition beim Aufnehmen des elektronischen Bauteils (1) am Aufnahmeort durch das Auftreffen der Unterkante (6) der hülsenförmigen Komponente (3) auf die Aufnahmefläche entlang der Längsachse (11) verschoben wird, so dass die Spitze der Vakuum-Pipette (2) bis auf einen durch die Bauhöhe des Bauteils (1) bedingten Versatz in einer durch die Unterkante (6) der hülsenförmigen Komponente (3) aufgespannten Ebene liegt, **dadurch gekennzeichnet, dass** die Unterkante (6) der hülsenförmigen Komponente (3) in der Transportposition um eine definierte Strecke in der sich verjüngenden Richtung der Vakuum-Pipette (2) derart versetzt ist, dass in der Transportposition die hülsenförmige Komponente (3) das elektronische Bauteil (1) seitlich komplett umschließt.

2. Vorrichtung nach Anspruch 1, wobei der Versatz der Unterkante (6) der hülsenförmigen Komponente (3) in der sich verjüngenden Richtung der Vakuum-Pipette (2) in der Transportposition durch einen Kontakt zwischen einem ersten, auf der Außenfläche der Vakuum-Pipette befindlichen Anschlag (7) und einem zweiten, sich auf der Innenfläche (4) der hülsenförmigen Komponente (3) befindlichen und mit dem ersten Anschlag korrespondierender Anschlag (8) bestimmt ist,
wobei sich der erste Anschlag (7) in Bezug zur Längsachse der Vakuum-Pipette (11) zwischen dem zweiten Anschlag (8) und der Unterkante (6) der hülsenförmigen Komponente (3) befindet.

3. Vorrichtung nach zumindest einem der vorhergehenden Ansprüche, wobei die hülsenförmige Komponente (3) einen runden Querschnitt aufweist.

4. Vorrichtung nach Anspruch 2 oder Anspruch 2 und 3, wobei der erste Anschlag (7) und/oder der zweite Anschlag (8) als ringförmiger Steg ausgebildet sind.

5. Vorrichtung nach Anspruch 2, oder Anspruch 2 und 3 oder Anspruch 4, wobei die hülsenförmige Komponente (3) aus zumindest zwei Teilkomponenten besteht, die in Kontakt sind,
wobei eine erste Teilkomponente (12) den zweiten Anschlag (8) umfasst und eine zweite Teilkomponente (13) eine Hülse (9) umfasst.

6. Vorrichtung nach zumindest einem der vorhergehenden Ansprüche, wobei die hülsenförmige Komponente (3) oberhalb der Unterkante (6) eine Verjüngung und/oder einen verkleinerten Querschnitt aufweist.

7. Vorrichtung nach zumindest einem der vorhergehenden Ansprüche, wobei an der Innenfläche (4) der hülsenförmigen Komponente (3) zumindest ein dritter Steg (10) vorgesehen ist, der die Oberseite des elektronischen Bauteils (1) zumindest teilweise abdeckt.

8. Vorrichtung nach zumindest einem der vorhergehenden Ansprüche, wobei die hülsenförmige Komponente (3) zumindest teilweise aus einem elektrisch leitfähigen Material, insbesondere einem ESD-leitfähigen Material besteht.

9. Vorrichtung nach zumindest einem der vorhergehenden Ansprüche, wobei die hülsenförmige Komponente (3) Aussparungen und/oder Durchbohrungen aufweist.

10. Vorrichtung nach zumindest einem der vorhergehenden Ansprüche, wobei es sich bei dem elektronischen Bauteil (1) um ein SMD Bauteil handelt.

11. Vorrichtung nach zumindest einem der Ansprüche 1 bis 9, wobei es sich bei dem elektronischen Bauteil (1) um ein Bauteil mit zumindest einem Anschluss-Stift handelt.

12. Verfahren zum automatisierten Bestücken einer Leiterplatte mit zumindest einem elektronischen Bauteil (1), mit einer Vorrichtung gemäß Anspruch 1, folgende Verfahrensschritte umfassend:
- Das elektronische Bauteil (1) wird durch die Vakuum-Pipette (2), welche zumindest teilweise von einer um die Längsachse der Vakuum-Pipette (11) verschiebbaren hülsenförmigen Komponente (3) umgeben ist, am Aufnahmeort in einer Aufnahmeposition von einer Aufnahmefläche aufgenommen, wobei beim Aufnehmen des elektronischen Bauteils (1) am Aufnahmeort durch das Auftreffen der Unterkante (6) der hülsenförmigen Komponente (3) auf die Aufnahmefläche entlang der Längsachse (11) verschoben wird, so dass die Spitze der Vakuum-Pipette (2) in der Aufnahmeposition bis auf einen durch die Bauhöhe des Bauteils (1) bedingten Versatz in einer durch die Unterkante (6) der hülsenförmigen Komponente (3) aufgespannten Ebene liegt;
- Das elektronische Bauteil (1) wird durch die Vakuum-Pipette (2) zu einem Zielort auf der Leiterplatte transportiert, wobei die hülsenförmige Komponente (3) auf dem Transportweg um eine definierte Strecke in der sich verjüngenden Richtung der Vakuum-Pipette (2) derart versetzt ist, dass in der Transportposition das elektronische Bauteil (1) von der hülsenförmigen Komponente (3) seitlich komplett umschlossen wird;
- Das elektronische Bauteil (1) wird durch die Vakuum-Pipette (2) am Zielort auf der Leiterplatte positioniert, wobei die hülsenförmige Komponente (3) beim Positionieren des elektronischen Bauteils (1) am Zielort durch das Auftreffen der Unterkante (6) der hülsenförmigen Komponente (3) auf die Leiterplatte entlang der Längsachse verschoben wird, so dass die Spitze der Vakuum-Pipette (2) bis auf einen durch die Bauhöhe des Bauteils (1) bedingten Versatz in einer durch die Unterkante (6) der hülsenförmigen Komponente (3) aufgespannten Ebene liegt

13. Verfahren nach Anspruch 12, wobei der Versatz der Unterkante (6) der hülsenförmigen Komponente (3) in der Transportposition durch das Eigengewicht der hülsenförmigen Komponente (3) bewirkt wird.

## Claims

1. Apparatus for the automated assembly of a printed circuit board with at least one electronic component (1), comprising
- a vacuum pipette (2) that tapers into a point, wherein the vacuum pipette (2) is configured to pick up the electronic component (1) from a pickup surface in a pickup position at a pickup point, to transport it in a transportation position on a transport path and to place it on the printed circuit board at a target point, and
- a sleeve-shaped component (3), which surrounds the vacuum pipette (2) in a partial area and which is arranged in a movable manner in the direction of the longitudinal axis of the vacuum pipette (11),
wherein the interior surface (4) of the sleeve-shaped component (3) and the outer surface (5) of the vacuum pipette (2) are designed in such a way that, in the pickup position, when the electronic component (1) is picked up at the pickup point movement takes place along the longitudinal axis (11) as a result of the contact between the lower edge (6) of the sleeve-shaped component (3) on the pickup surface such that, with the exception of an offset caused by the height of the component (1), the tip of the vacuum pipette (2) is located on a plane extending through the lower edge (6) of the sleeve-shaped component (3),
**characterized in that**
in the transportation position the lower edge (6) of the sleeve-shaped component (3) is offset by a defined section in the tapered direction of the vacuum pipette (2) in such a way that the sleeve-shaped component (3) completely surrounds the electronic component (1) at the side in the transportation position.

2. Apparatus as claimed in Claim 1, wherein, in the transportation position, the offset of the lower edge (6) of the sleeve-shaped component (3) in the tapered direction of the vacuum pipette (2) is determined by a contact between a first stop (7) located on the outer surface of the vacuum pipette (2) and a second stop (8) that is located on the interior surface (4) of the sleeve-shaped component (3) and corresponds to the first stop,
wherein, in relation to the longitudinal axis of the vacuum pipette (11), the first stop (7) is located between the second stop (8) and the lower edge (6) of the sleeve-shaped component (3).

3. Apparatus as claimed in at least one of the previous claims, wherein the sleeve-shaped component (3) has a round cross-section.

4. Apparatus as claimed in Claim 2 or in Claim 2 and 3, wherein the first stop (7) and/or the second stop (8) is/are designed as an annular ridge.

5. Apparatus as claimed in Claim 2, or in Claim 2 and 3 or Claim 4, wherein the sleeve-shaped component (3) consists of at least two sub-components which are in contact with one another,
wherein a first subcomponent (12) comprises the first stop (8) and a second subcomponent (13) comprises a sleeve (9).

6. Apparatus as claimed in at least one of the previous claims, wherein the sleeve-shaped component (3) has a tapering and/or a smaller cross-section above the lower edge (6).

7. Apparatus as claimed in at least one of the previous claims, wherein at least a third ridge (10), which at least partially covers the top side of the electronic component (1), is provided on the interior surface (4) of the sleeve-shaped component (3).

8. Apparatus as claimed in at least one of the previous claims, wherein the sleeve-shaped component (3) consists at least partially of an electrically conductive material, particularly an ESD-conductive material.

9. Apparatus as claimed in at least one of the previous claims, wherein the sleeve-shaped component (3) has recesses and/or through-holes.

10. Apparatus as claimed in at least one of the previous claims, wherein the electronic component (1) is an SMD component.

11. Apparatus as claimed in at least one of the Claims 1 to 9, wherein the electronic component (1) is a component with at least one connection pin.

12. Procedure for the automated assembly of a printed circuit board with at least one electronic component (1), with an apparatus as claimed in Claim 1,
said procedure comprising the following steps:
- The electronic component (1) is picked up by the vacuum pipette (2) from a pickup surface in a pickup position at the pickup point, wherein said vacuum pipette (2) is at least partially surrounded by a sleeve-shaped component (3) which can be moved around the longitudinal axis of the vacuum pipette (11), wherein when the electronic component (1) is picked up at the pickup point movement takes place along the longitudinal axis (11) as a result of the contact between the lower edge (6) of the sleeve-shaped component (3) on the pickup surface such that, with the exception of an offset caused by the height of the component (1), the tip of the vacuum pipette (2) in the pickup position is located on a plane extending through the lower edge (6) of the sleeve-shaped component (3);
- The electronic component (1) is transported by the vacuum pipette (2) to a target position on the printed circuit board, wherein, on the transportation path, the sleeve-shaped component (3) is offset by a defined section in the tapered direction of the vacuum pipette (2) in such a way that, in the transportation position, the sleeve-shaped component (3) completely surrounds the electronic component (1) at the side,
- The electronic component (1) is positioned at the target position on the printed circuit board by the vacuum pipette (2), wherein, when positioning the electronic component (3) at the target position, the sleeve-shaped component (3) is moved along the longitudinal axis as a result of the lower edge (6) of the sleeve-shaped component (3) coming into contact with the printed circuit board such that, with the exception of an offset caused by the height of the component (1), the tip of the vacuum pipette (2) is located on a plane extending through the lower edge (6) of the sleeve-shaped component (3).

13. Procedure as claimed in Claim 12, wherein, in the transportation position, the offset of the lower edge (6) of the sleeve-shaped component (3) is caused by the weight of the sleeve-shaped component (3).

## Revendications

1. Dispositif destiné à l'implantation automatisée d'un circuit imprimé avec au moins un composant électrique (1), comprenant
- une pipette à vide (2) se rétrécissant en une pointe, la pipette à vide (2) étant conçue de telle sorte à prélever le composant électronique (1) en un emplacement de prélèvement, dans une position de prélèvement, par une surface de prélèvement, à le transporter sur un chemin de transport, dans une position de transport, et à le positionner sur un emplacement cible sur le circuit imprimé, et
- un composant en forme de douille (3), qui entoure la pipette à vide (2) dans une zone partielle, et qui est disposé de façon coulissante en direction de l'axe longitudinal de la pipette à vide (11),
la surface intérieure (4) du composant en forme de douille (3) et la surface extérieure (5) de la pipette à vide (2) étant conçues de telle sorte que dans la position de prélèvement, lors du prélèvement du composant électronique (1) sur l'emplacement de prélèvement, le composant en forme de douille (3) est décalé le long de l'axe longitudinal (11) lors de l'impact du bord inférieur (6) du composant en forme de douille (3) sur la surface de prélèvement, si bien que la pointe de la pipette à vide (2) se trouve, hormis un décalage dû à la hauteur de construction du composant (1), dans un plan passant par le bord inférieur (6) du composant en forme de douille (3),
**caractérisé**
**en ce que** le bord inférieur (6) du composant en forme de douille (3) est décalé, dans la position de transport, d'une distance définie dans la direction de rétrécissement de la pipette à vide (2), de telle sorte que dans la position de transport, le composant en forme de douille (3) entoure complètement et latéralement le composant électronique (1).

2. Dispositif selon la revendication 1, pour lequel le décalage du bord inférieur (6) du composant en forme de douille (3) dans la direction de rétrécissement de la pipette à vide (2), dans la position de transport, est déterminé par un contact entre une première butée (7) se trouvant sur la surface extérieure de la pipette à vide (2) et une deuxième butée (8) se trouvant sur la surface intérieure (4) du composant en forme de douille (3), et correspondant à la première butée,
la première butée (7) se trouvant par rapport à l'axe longitudinal (11) de la pipette à vide (2) entre la deuxième butée (8) et le bord inférieur (6) du composant en forme de douille (3).

3. Dispositif selon au moins l'une des revendications précédentes, pour lequel le composant en forme de douille (3) présente une section circulaire.

4. Dispositif selon la revendication 2 ou la revendication 2 et 3, pour lequel la première butée (7) et/ou la deuxième butée (8) est/sont conçue(s) en tant que nervure annulaire.

5. Dispositif selon la revendication 2, ou la revendication 2 et 3 ou la revendication 4, pour lequel le composant en forme de douille (3) est constitué au minimum de deux sous-composants, qui sont en contact,
un premier sous-composant (12) comprenant la deuxième butée (8) et un deuxième sous-composant (13) comprenant une douille (9).

6. Dispositif selon au moins l'une des revendications précédentes, pour lequel le composant en forme de douille (3) présente au-dessus du bord inférieur (6) un rétrécissement et/ou une section réduite.

7. Dispositif selon au moins l'une des revendications précédentes, pour lequel est prévue, sur la surface intérieure (4) du composant en forme de douille (3), au moins une troisième nervure (10), qui recouvre au moins partiellement la partie supérieure du composant électronique (1).

8. Dispositif selon au moins l'une des revendications précédentes, pour lequel le composant en forme de douille (3) est constitué au moins partiellement d'un matériau électriquement conducteur, notamment un matériau conducteur d'électricité statique.

9. Dispositif selon au moins l'une des revendications précédentes, pour lequel le composant en forme de douille (3) présente des évidements et/ou des trous traversants.

10. Dispositif selon au moins l'une des revendications précédentes, pour lequel, concernant le composant électrique (1), il s'agit d'un composant CMS.

11. Dispositif selon au moins l'une des revendications 1 à 9, pour lequel, concernant le composant électrique (1), il s'agit d'un composant muni d'au moins une broche de raccordement.

12. Procédé destiné à l'implantation automatisée d'un circuit imprimé avec au moins un composant électronique (1), avec un dispositif selon la revendication 1, lequel procédé comprend les étapes suivantes :
- Le composant électronique (1) est prélevé par la pipette à vide (2), laquelle est entourée au moins partiellement d'un composant en forme de douille (3) coulissant autour de l'axe longitudinal (11) de la pipette à vide (2), sur l'emplacement de prélèvement, dans une position de prélèvement, par une surface de prélèvement, le composant en forme de douille (3) étant décalé le long de l'axe longitudinal (11) lors de l'impact du bord inférieur (6) du composant en forme de douille (3) sur la surface de prélèvement, si bien que la pointe de la pipette à vide (2) se trouve, hormis un décalage dû à la hauteur de construction du composant (1), dans un plan passant par le bord inférieur (6) du composant en forme de douille (3) ;
- Le composant électronique (1) est transporté par la pipette à vide (2) vers un emplacement cible sur le circuit imprimé, le composant en forme de douille (3) étant décalé sur le chemin de transport d'une distance définie dans la direction de rétrécissement de la pipette à vide (2), de telle sorte que dans la position de transport, le composant en forme de douille (3) entoure complètement et latéralement le composant électronique (1),
- Le composant électronique (1) est positionné par la pipette à vide (2) sur l'emplacement cible du circuit imprimé, le composant en forme de douille (3) étant décalé lors du positionnement du composant électronique (1) sur l'emplacement cible lors de l'impact du bord inférieur (6) du composant en forme de douille (3) sur le circuit imprimé le long de l'axe longitudinal, si bien que la pointe de la pipette à vide (2) se trouve, hormis un décalage dû à la hauteur de construction du composant (1), dans un plan passant par le bord inférieur (6) du composant en forme de douille (3)

13. Procédé selon la revendication 12, pour lequel le décalage du bord inférieur (6) du composant en forme de douille (3) est occasionné, dans la position de transport, par le poids propre du composant en forme de douille (3).
